# EUROPEAN PATENT SPECIFICATION

(11) **EP 1 795 909 B1**
(45) Date of publication and mention of the grant of the patent: **20.02.2008**
(21) Application number: 05111903.0
(22) Date of filing: 09.12.2005
(51) Int. Cl.: G01R 31/319, G06F 1/16

(54) **Transport frame and optional fixture for battery powered electronic devices**
Transportrahmen und fakultative Halteeinrichtung für ein Batteriebetriebenes elektronisches Gerät
Bâti de transport et dispositif de fixation optionnel pour dispositifs électroniques alimentés par batterie

(43) Date of publication of application: 13.06.2007
(73) Proprietor: Research In Motion Limited, Waterloo, Ontario N2L 3W8 (CA)
(72) Inventor: Ivannikov, Arkady, Mississauga Ontario L4W 2S8 (CA); Mok, Winston Y.W., Scarborough Ontario M1V 2T5 (CA); Gallagher, Nial S., Cambridge Ontario N1R 5S5 (CA)
(74) Representative: Rickard, David John

(56) References cited:
- US-A- 5 052 943
- US-A- 6 130 520
- US-B1- 6 479 184

## Description

This invention relates to handling of battery-powered handheld electronic devices, and more particularly to a transport frame which holds the device. If desired, the transport frame may be mounted in a fixture for quality control testing or other purposes.

Although particularly developed for use in quality control testing of handheld wireless communication devices, the invention is applicable to handling of any small electronic device requiring the use of a battery, not just wireless devices, and whether for testing purposes or otherwise.

When testing such devices, reliable handling is important in order to obtain consistent measurement. Commonly, fixturing and various types of guides and retainers are used, which contact external surfaces of the device to obtain a secure grip. These often result in some risk of damaging or scratching the device, due to contact with the guides or retainers. Furthermore, there can be an increased probability of inaccurate measurements due to stresses on the device introduced by the guides and retainers.

There is a therefore an ongoing need for ways of transporting and mounting such devices for testing, with minimized impact on the device. This is particularly important where, as with many devices, there is 100% testing of every device, not just occasional samples.

The document US-B-6 479 184 discloses a PDA battery buckling device comprising an externally-mounted battery to provide longer life than the battery mounted in the normal battery compartment of the PDA. The document US-A-5 052 943 discloses a recharging and data retrieval apparatus using a frame having electrical contact elements at its inner end for receiving a hand-held device.

### GENERAL

According to one aspect of the invention, the transport frame preferably has engagement means configured to engage and hold the device via the battery compartment and/or the securing means for the battery compartment cover only.

According to another aspect of the invention, the transport frame preferably is in combination with a fixture, for example at a testing location, the transport frame and fixture being configured in complementary fashion whereby the transport frame is mountable in the fixture.

Details of aspects of the invention, and non-limiting examples of the invention, will be provided in the following detailed description.

### BRIEF DESCRIPTION OF THE DRAWINGS

Examples of the invention will now be described, by way of example only, with reference to the attached drawings, in which:
Fig. 1 is an exploded perspective view showing a battery-powered electronic device and an exemplary transport frame;
Fig. 2 is an exploded perspective view showing the device mounted on the transport frame, and a fixture;
Fig. 3 is a perspective view showing the device mounted on the transport frame, and the transport frame mounted in the fixture;
Fig. 4 is an exploded perspective view showing the transport frame and the device;
Fig. 5 is a similar exploded perspective view showing the transport frame and the device from a different angle;
Fig. 6 is a perspective view showing back of the transport frame;
Fig. 7 is a side cross-section showing the device about to be positioned on the transport frame, with the transport frame actuator in a ready position;
Fig. 8 is a corresponding side cross-section showing the device positioned on the transport frame, with the transport frame actuator still in a ready position;
Fig. 9 is a corresponding side cross-section showing the device positioned on the transport frame, with the transport frame actuator in an intermediate position;
Fig. 10 is a corresponding side cross-section showing the device positioned on the transport frame, with the transport frame actuator in a locked position;
Fig. 11 is an exploded perspective view showing a battery-powered electronic device mounted on another example of a transport frame, ready for positioning in a fixture;
Fig. 12 is a perspective view showing the device mounted on the Fig. 11 transport frame and positioned in the fixture;
Fig. 13 is an exploded perspective view showing the Fig. 11 transport frame and the device;
Fig. 14 is a perspective view showing the Fig. 11 transport frame;
Fig. 15 is a side cross-section showing the device positioned on the Fig. 11 transport frame, with the transport frame actuator in a ready position; and
Fig. 16 is a corresponding side cross-section showing the device positioned on the transport frame, with the transport frame actuator in a locked position.

### DESCRIPTION OF PREFERRED EMBODIMENTS

The transport frame holds the device using a battery compartment or battery compartment area of the device only, rather than external features of the device, and is defined by the accompanying claims. If desired, the transport frame may be mounted in a fixture, for example at a testing location.

For convenience, most references herein will be to mounting the device on a transport frame for testing purposes. However, it should be appreciated that the transport frame may be useful in any other situation where it is desired to mount or transport the device without handling it externally, and the invention is therefore not limited to testing applications.

In the following description, specific examples of the invention will be described. For purposes of explanation, specific configurations and details are set forth in order to provide a thorough understanding of the invention. However, it will be apparent to one skilled in the art that the invention may be practiced without the specific details. Furthermore, well-known features may be omitted or simplified in order not to obscure the examples being described.

The transport frame 1 supports and retains the device 2 by emulating a battery, in the sense that the transport frame provides engagement elements which fit into the device's battery compartment 3 and/or its battery compartment cover securing means, to retain the device. The frame can then be handled to transport the device and if desired mount it in a fixture for testing or other purposes, avoiding or minimizing contact with the external surfaces of the device. Typically, the transport frame is configured to mate with a fixture 4, at a fixed test location. Thus in an assembly-line process, devices can be mounted onto transport frames at one or more locations, and carried or transported to the test location for mounting in the fixture for testing. Once the testing is completed, the transport frame and device can be removed from the fixture, and the device can be removed from the transport frame for further processing, for example packaging for sale.

### First Example

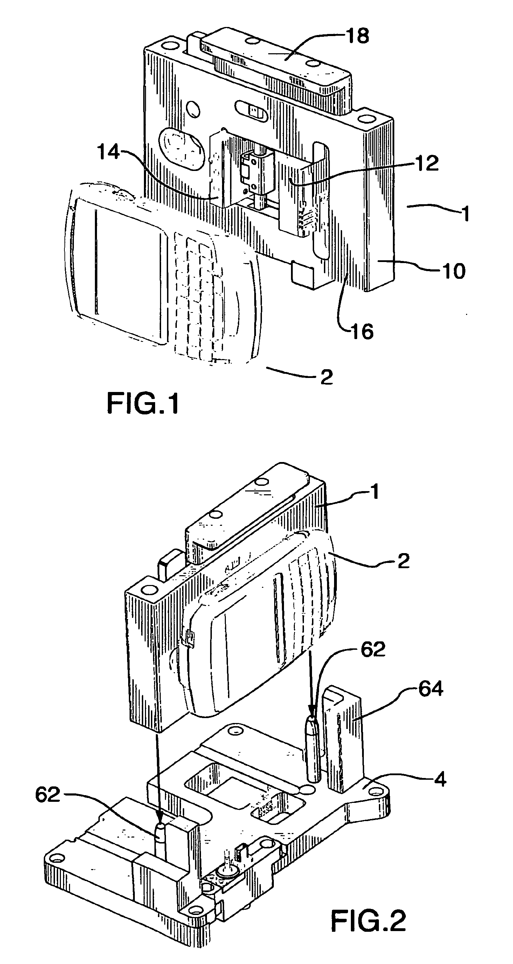

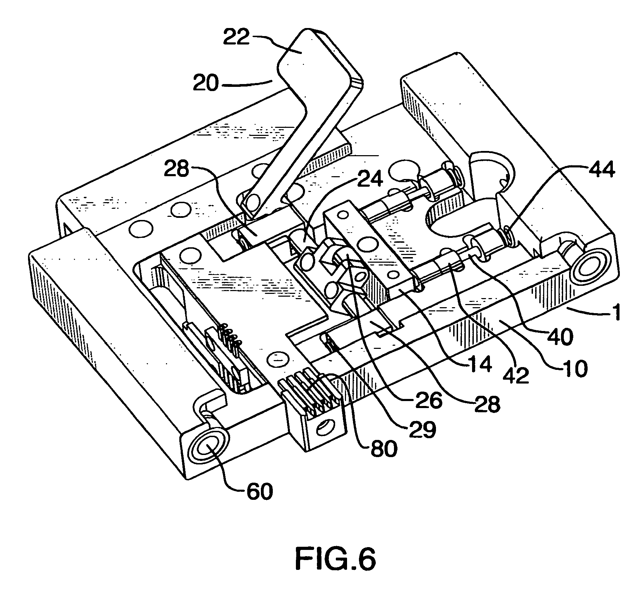

A first example of the invention is illustrated in Figs. 1-10. Fig. 1 shows the transport frame 1, having a body 10, with a fixed block 12 and a movable block 14 as the engagement elements, both extending from a rear surface 16 thereof. The body 10 preferably has a grippable feature or handle 18 extending therefrom, allowing the transport frame to be easily moved from one location to another, whether manually or via automation.

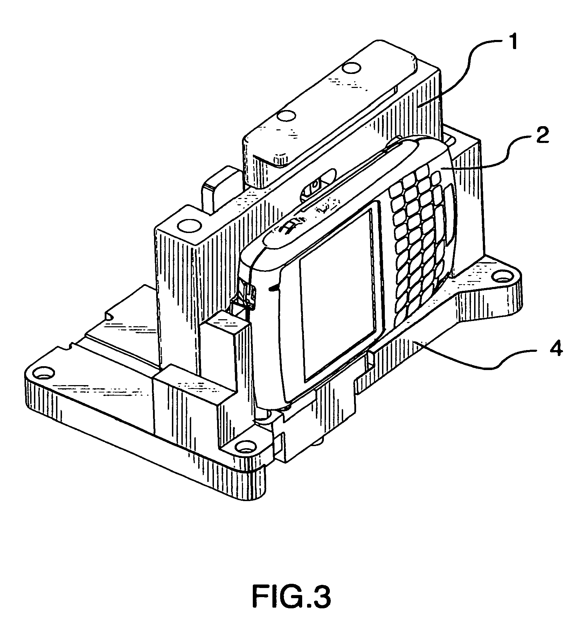

Fig. 2 shows the transport frame 1 and device 2 positioned for mounting on a fixture 4, and Fig. 3 shows the transport frame and device mounted on the fixture.

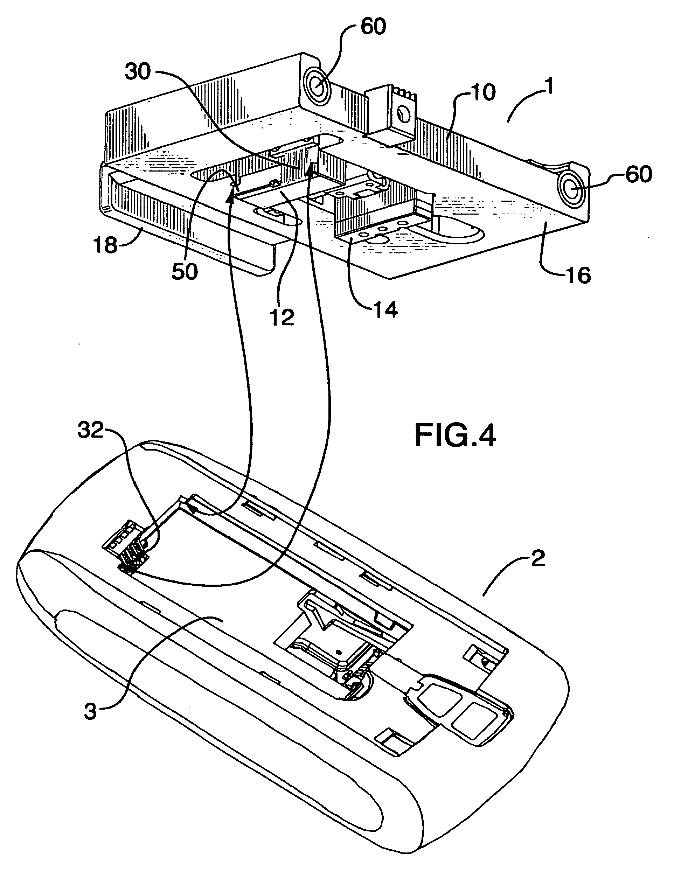

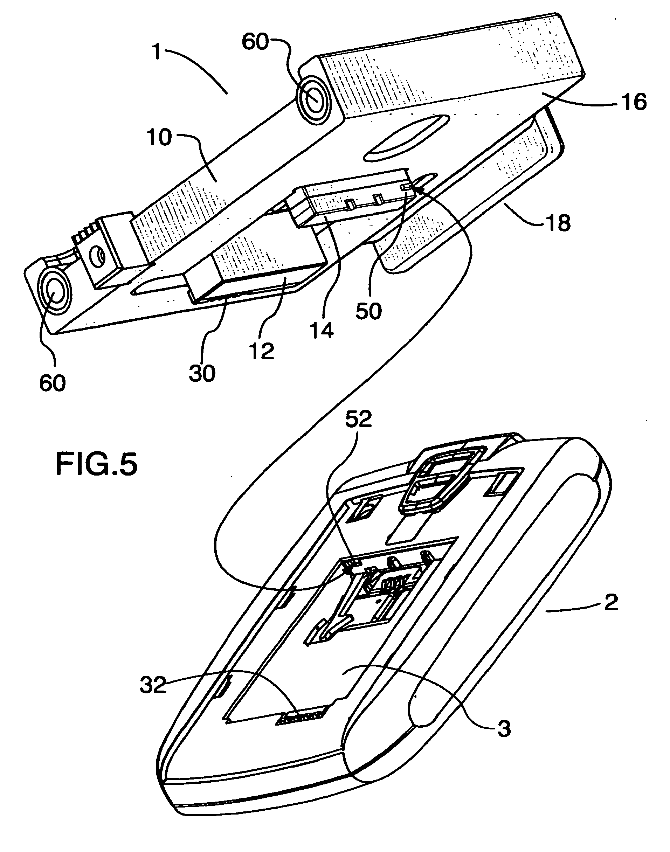

As shown in Figs. 4 and 5, the fixed and movable blocks 12 and 14 fit within the battery compartment 3. For testing of the device, one of the blocks, in this example the fixed block 12, may include electrical contacts 30 which mate with electrical contacts 32 within the battery compartment to provide power to the device while it is being tested. The powering of the transport frame will be understood by one skilled in the art, and typically may be supplied to the transport frame by the fixture 4 once the transport frame is mounted therein, for example via contacts 80 on the transport frame engaging contacts 82 on the fixture, as shown in Fig. 2. The blocks 12 and 14 each have portions which engage with complementary features in the battery compartment. The actuator 20 moves the blocks from a removal position where they are readily insertable in the battery compartment, to an expanded position where they are spaced farther apart to secure the device using the battery compartment.

The movable block 14 is mounted on a proximal end of a pair of shafts 40 which are movable axially through bushings 42. Springs 44 act against preferably larger-diameter distal ends of the shafts, to bias the shafts and hence the movable block 14 towards the fixed block 12. The actuator 20 operates to overcome that bias, to move the movable block away from the fixed block.

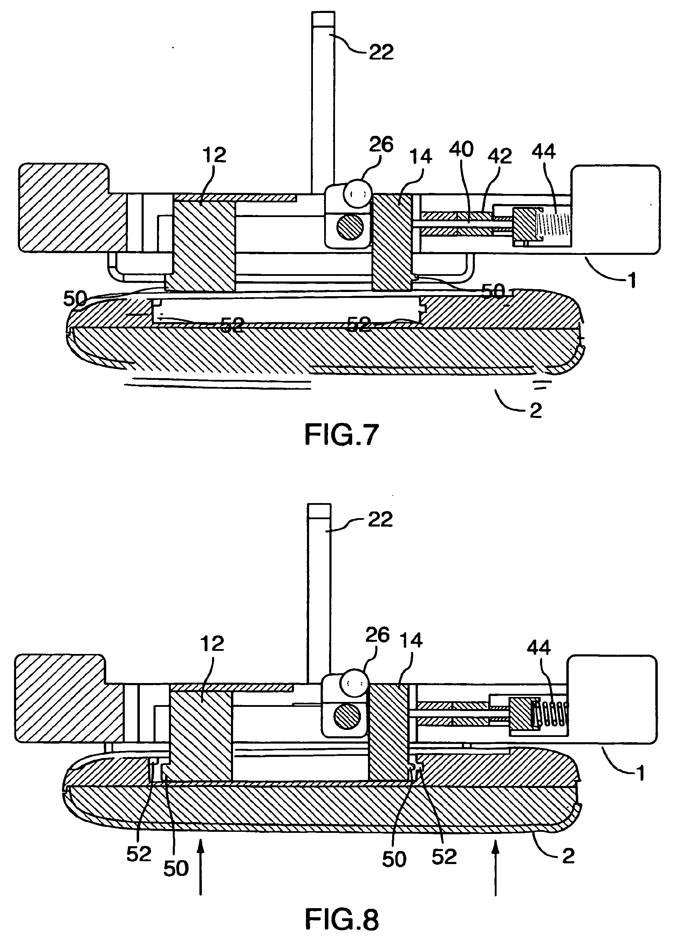

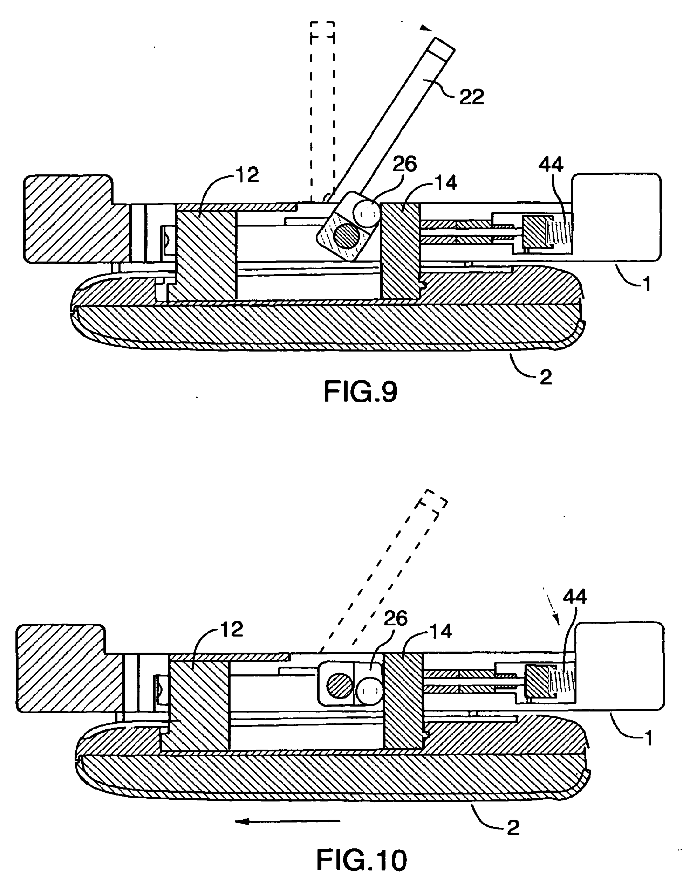

The actuator 20 includes a lever 22 mounted on a shaft 24. A cam 26 is also mounted on the shaft, so that operation of the lever produces rotation of the cam. The cam bears against the movable block 14, so that movement of the lever from the "ready" position shown in Figs. 7 and 8, through the intermediate position shown in Fig. 9, to the locked position shown in Fig. 10, moves the movable block 14 to an "expanded" position where it is farthest from the fixed block 12. As can be seen from these drawings, this results in tabs 50 or other engagement features on the fixed and movable blocks engaging recesses, slots or other such receptors 52 in the battery compartment 3, resulting in the device 2 thereby being secured on the frame 1. As can be seen from Fig. 10, the cam goes slightly "over center" against the spring force to get to the locked position, resulting in it staying in that position once placed there.

The shaft 24 could be mounted directly on the body 10 of the frame. When the actuator was moved to the locked position, this would result in the fixed and movable blocks 12 and 14 being at a fixed minimum expanded distance from each other. That could be acceptable, but it is preferable not to have that distance fixed, and therefore preferably the shaft is permitted to float somewhat. This is accomplished by mounting the shaft on two opposing shaft mounts 28, which are free to move a limited distance within the body 10. Shaft biasing springs 29 bias the shaft away from the fixed block. Thus in the locked position, the movable block has a limited degree of freedom in both directions away from its basic locked position, i.e. slightly towards or slightly away from the fixed block. This has the significant advantage that the pressure of the blocks against the battery compartment of the device is governed by the springs 44 and 29, not by the mechanical dimensions. This of course results in more consistency, given the inevitable small differences in dimensions due to normal manufacturing tolerances.

Movement of the actuator 20 through the intermediate position via its lever 22 may result in one of the tabs 50 mating with a complementary recess 52 within the battery compartment to partially lock the device against the transport frame, as illustrated, or in both tabs moving part way towards their respective recesses. After the device 2 has been mounted to the transport frame 1, the assembly may then mounted in an exemplary fixture 4 as shown in Figs. 2 and 3. Although many different ways of mounting the transport frame in the fixture could be employed, and many different fixture configurations could be contemplated, in this example the body 10 includes a pair of holes 60 for mating with a pair of posts 62 located on the fixture. The fixture also includes a guide 64 for aligning and positioning the transport frame as it is being mounted to the fixture. Once the transport frame is mounted to the fixture, various quality control tests may be performed on the device. These tests may include, but are not limited to RF alignment and tests, audio tests, display tests, charger tests, etc.

Notwithstanding the preceding, as stated previously, the invention is not limited to testing applications, nor to any specific testing. It may be convenient to mount the device in a fixture for purposes other than testing.

### Second Example

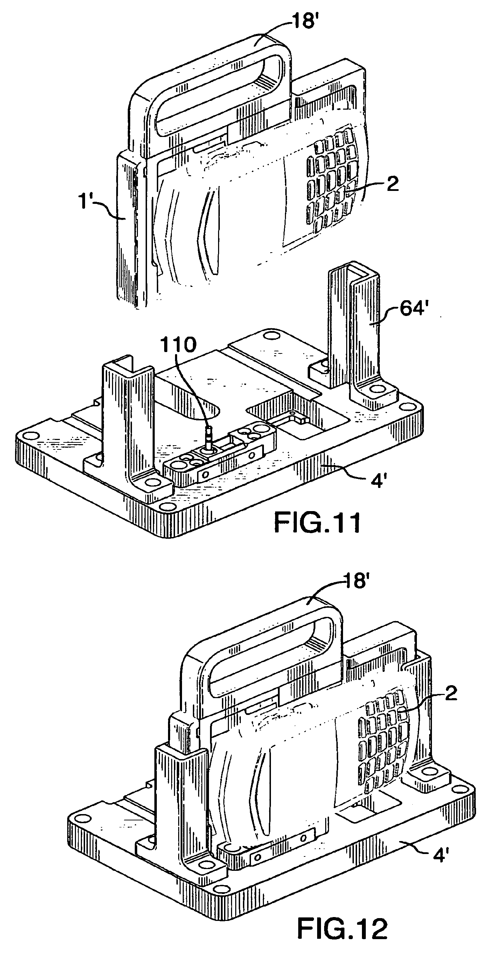

In the preceding example, the locking of the frame to the device takes place entirely within the battery compartment, via a movable block. However, in another example of the invention, shown in Figs. 11-16, the locking is partly within the battery compartment, and partly making use of the battery compartment cover securing means. Other examples could conceivably make use of battery compartment cover securing means only, or of features within the battery compartment other than those specifically described herein.

In this second example of the invention, there are still opposing engagement elements which move apart from each other to lock the device 2 in place. However, in this example, the transport frame 1' has a main body 102, a sliding portion 104 and an actuator 20' with a lever 22'. The main body has lugs 106 extending therefrom which engage battery compartment cover securing slots 107. The sliding portion 104 is movable away from the main body 102 by operation of the lever 22', and has an extension 108 therefrom which corresponds in effect to the movable block 14 of the first example. The main body preferably has a handle 18'.

Fig. 11 shows this example with the device mounted on it, ready for mounting in a fixture 4', including guides 64'. Fig. 11 shows that a simulated earphone connector 110 can be provided on the fixture if desired, to plug into an earphone jack on the device for audio output testing. Fig. 12 shows the device and frame mounted in the fixture.

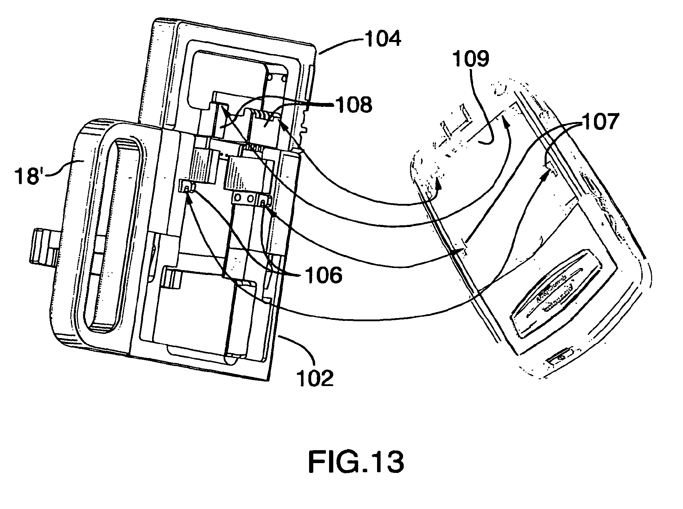

Fig. 13 illustrates the features used to secure the device to the frame, i.e. the lugs 106 engaging the battery compartment cover securing slots 107, and the extension 108 which extends into a recess 109 in the battery compartment.

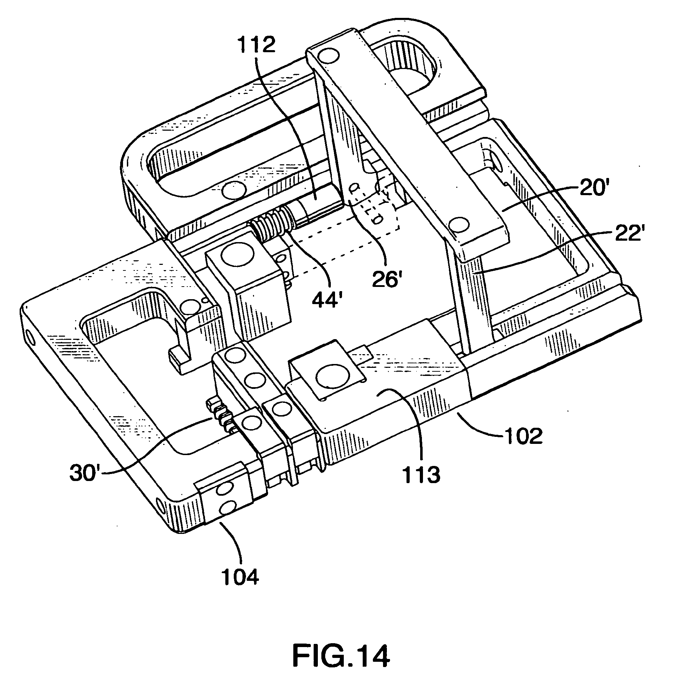

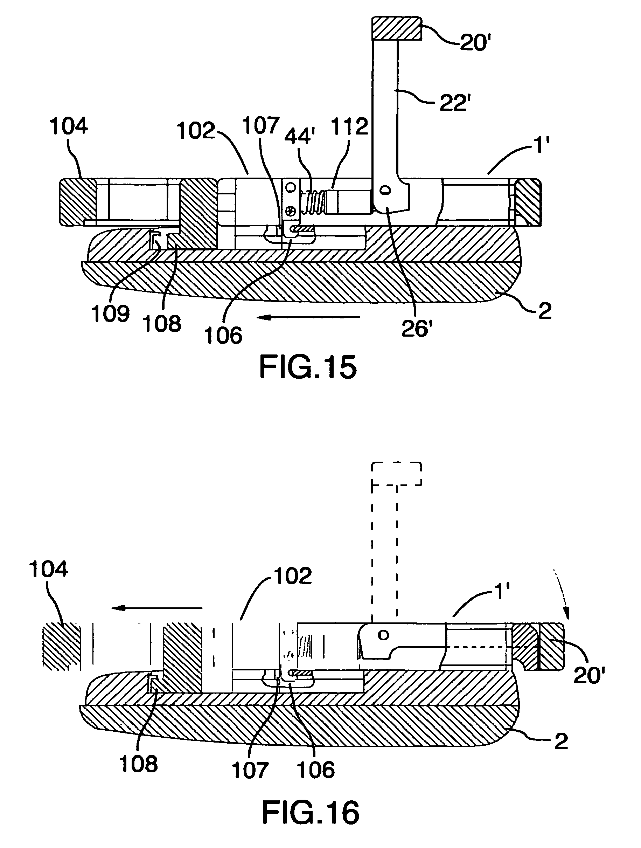

Figs. 14-16 show the operation of the transport frame. A pair of shafts 112 are slidably housed within the main body 102 and are connected to the sliding portion 104, so that when the shafts move axially, the sliding portion moves towards or away from the main body. (In Fig. 14, a cover plate has been removed to show one of the shafts, the other being hidden under cover plate 113.) As seen best in Figs. 15 and 16, the actuator 20' and its lever 22' have cam portions 26' which act against the ends of the shafts 112 to move the sliding portion 104 away from the main body when the lever is moved from the Fig. 15 "ready" position to the Fig. 16 "locked" position. A return spring 44' biases the sliding portion towards the main body, so that it is only expanded when the actuator and lever are moved to the Fig. 16 position. The cam design is again such that it goes "over center" so as to remain in the Fig. 16 locked position once there.

Note that the sliding portion 104 may be provided with electrical contacts 30' to engage corresponding contacts in the device. The contacts are wired through the frame to a second set of contacts (not shown). When the frame is mounted on the fixture 4', this second set of contacts connects with power supplied to the fixture in order to provide power to the battery contacts of the device.

### General

Several examples of the invention are described above. Variations of those examples may be or become apparent to those of ordinary skill in the art upon reading the foregoing description. It is expected that such persons will employ such variations as appropriate, and it is therefore expected that the invention may be practiced otherwise than as specifically described above. Accordingly, the invention is defined not by the above examples, but by the claims appended hereto, and includes such variations on the above examples as may be adopted by those knowledgeable in the field of the invention.

Without limiting the generality of the foregoing statement, some specific examples of possible variations may include the following, though others may be apparent to those knowledgeable in the field of the invention.

The invention may not necessarily involve a fixture, for testing or otherwise. In some applications, mounting the device on the transport frame may suffice for that application, and there may be no need to place the device and transport frame in any fixture.

Details of size, shape and specific configuration of the transport frame and the features by which it engages the device may obviously be varied according to the desired engagement details and according to the configuration of the battery compartment and battery compartment area of the device. Similarly, details of any fixture, for testing or otherwise, may also vary.

The examples described above both include cam actuation via a lever. However, it is conceivable that the engagement means might not involve any elements requiring positive actuation. For example, the engagement means could simply snap into position in the battery compartment in a manner similar to a battery. Alternatively, there could be resilient engagement elements which displace slightly on insertion in the battery compartment, and are biased by that resilience towards a locked position. Or there could be movable elements as in the above examples, without positive actuation, i.e. the elements could be biased apart, for example by one or more springs, and insertion in the battery compartment could compress the spring or springs, or they could be manually compressed during or before insertion. The spring or springs would then move the elements apart to a locked position.

## Claims

1. A transport frame (1) for a battery-operated electronic device (2), said device having a battery compartment (3) for receiving a battery and having a removable battery compartment cover securable over said battery compartment via battery compartment cover securing means (107), **characterized by** said transport frame having engagement means (12, 14; 106, 108) configured to engage and hold said device via only said battery compartment and/or said battery compartment cover securing means.

2. A transport frame as claimed in claim 1, wherein said frame is further **characterized by** first and second engagement elements (12, 14) positionable for engagement with only said battery compartment (3) and/or said battery compartment cover securing means (107), said engagement elements being movable between a ready position and a locked position where they are farther apart than in said ready position.

3. A transport frame as claimed in claim 2, wherein said frame is further **characterized by** actuation means (20, 22, 24, 26) for moving said first and second engagement elements away from each other to secure said frame to said device.

4. A transport frame as claimed in claim 3, wherein said actuation means is further **characterized by** a spring-biased cam-actuating lever (22), movable between a release position and a locking position, said engagement elements being farther from each other in said locking position than in said release position.

5. A transport frame as claimed in any one of claims 2 to 4, wherein said frame is further **characterized by** a body having a fixed block (12) extending from a rear surface (16) thereof and constituting one of said first and second engagement elements, and having a movable block (14) extending from a rear surface thereof and constituting the other of said first and second engagement elements.

6. A transport frame as claimed in any one of claims 2 to 4, wherein said frame is further **characterized by** a main body (102) having one of said first and second engagement elements extending therefrom, and a slidable portion (104) movable towards and away from said main body, said slidable portion having the other of said first and second engagement elements extending therefrom.

7. A transport frame as claimed in any one of claims 1 to 6, in combination with a fixture (4, 4'), said transport frame and fixture being configured in complementary fashion whereby said transport frame is mountable in said fixture.

8. A combination of a battery-operated electronic device (2), said device having a battery compartment (3) for receiving a battery and having a removable battery compartment cover securable over said battery compartment via battery compartment cover securing means (107), and a transport frame as claimed in any one of claims 1 to 7, wherein said transport frame is engaged only with said battery compartment and/or said battery compartment cover securing means of said electronic device.

9. A method of handling a battery-operated electronic device (2), said device having a battery compartment (3) for receiving a battery and having a removable battery compartment cover securable over said battery compartment via battery compartment cover securing means (107), the method comprising:
combining the electronic device (2) with a transport frame as claimed in any one of claims 1 to 7 by engaging said transport frame only with said battery compartment and/or said battery compartment cover securing means of said electronic device.

10. A method as claimed in claim 9, wherein said method comprises a method of testing an electronic device, said method comprising the further steps of:
mounting the combined battery-operated electronic device (2) and transport frame to a test fixture;
testing the electronic device; and
demounting the combined electronic device and transport frame from the test fixture.

## Patentansprüche

1. Transportrahmen (1) für ein batteriebetriebenes elektronisches Gerät (2), wobei das Gerät ein Batteriefach (3) zum Aufnehmen einer Batterie mit einem abnehmbaren Batteriefachdeckel umfasst, der mithilfe von Batteriefachdeckelbefestigungsmitteln (107) über dem Batteriefach befestigt werden kann, **dadurch gekennzeichnet, dass** der Transportrahmen über Eingriffmittel (12, 14; 106, 108) verfügt, die so konfiguriert sind, dass sie in Eingriff mit dem Gerät kommen und dieses nur durch das Batteriefach und/oder die Batteriefachdeckelbefestigungsmittel gehalten wird.

2. Transportrahmen gemäß Anspruch 1, wobei der Rahmen des Weiteren **gekennzeichnet ist durch** erste und zweite Eingriffelemente (12, 14), die positionierbar sind, um nur in das Batteriefach (3) und/oder die Batteriefachdeckelbefestigungsmittel (107) einzugreifen, wobei die Eingriffelemente bewegbar sind zwischen einer Bereitschaftsposition und einer Verriegelungsposition, wo sie sich weiter voneinander entfernt befinden als in der Bereitschaftsposition.

3. Transportrahmen gemäß Anspruch 2, wobei der Rahmen des Weiteren **gekennzeichnet ist durch** Betätigungsmittel (20, 22, 24, 26) zum Bewegen der ersten und zweiten Eingriffelemente voneinander weg, um den Rahmen an dem Gerät zu befestigen.

4. Transportrahmen gemäß Anspruch 3, wobei die Betätigungsmittel des Weiteren **gekennzeichnet sind durch** einen unter Federvorspannung stehenden Nockenbetätigungshebel (22), der bewegbar ist zwischen einer Freigabeposition und einer Verriegelungsposition, wobei die Eingriffelemente sich in der Verriegelungsposition weiter voneinander entfernt befinden als in der Freigabeposition.

5. Transportrahmen gemäß jedem der Ansprüche 2 bis 4, wobei der Rahmen des Weiteren **gekennzeichnet ist durch** einen Grundkörper mit einem feststehenden Block (12), der ausgehend von einer Hinterfläche (16) davon verläuft und eines der ersten und zweiten Eingriffelemente bildet, und mit einem bewegbaren Block (14), der ausgehend von einer Hinterfläche davon verläuft und das andere der ersten und zweiten Eingriffelemente bildet.

6. Transportrahmen gemäß jedem der Ansprüche 2 bis 4, wobei der Rahmen des Weiteren **gekennzeichnet ist durch** einen Hauptkörper (102), von dem ausgehend eines der ersten und zweiten Eingriffelemente verläuft, und **durch** einen verschiebbaren Abschnitt (104), der auf den Hauptkörper zu und von diesem weg bewegbar ist, wobei ausgehend von dem verschiebbaren Abschnitt das andere der ersten und zweiten Eingriffelemente verläuft.

7. Transportrahmen gemäß jedem der Ansprüche 1 bis 6, in Kombination mit einer Halteeinrichtung (4, 4'), wobei der Transportrahmen und die Halteeinrichtung in einander ergänzender Weise konfiguriert sind, wodurch der Transportrahmen in der Halteeinrichtung montierbar ist.

8. Eine Kombination aus einem batteriebetriebenen elektronischen Gerät (2), wobei dieses Gerät ein Batteriefach (3) zum Aufnehmen einer Batterie sowie einen abnehmbaren Batteriefachdeckel umfasst, der mithilfe von Batteriefachdeckelbefestigungsmitteln (107) über dem Batteriefach befestigt werden kann, und aus einem Transportrahmen gemäß jedem der Ansprüche 1 bis 7, wobei der Transportrahmen nur in Eingriff mit dem Batteriefach und/oder den Batteriefachdeckelbefestigungsmitteln des elektronischen Gerätes steht.

9. Verfahren zur Handhabung eines batteriebetriebenen elektronischen Gerätes (2), wobei dieses Gerät ein Batteriefach (3) zum Aufnehmen einer Batterie sowie einen abnehmbaren Batteriefachdeckel umfasst, der mithilfe von Batteriefachdeckelbefestigungsmitteln (107) über dem Batteriefach befestigt werden kann, und das Verfahren umfasst:
das Kombinieren des elektronischen Gerätes (2) mit einem Transportrahmen gemäß jedem der Ansprüche 1 bis 7, indem der Transportrahmen nur mit dem Batteriefach und/oder den Batteriefachdeckelbefestigungsmitteln des elektronischen Gerätes in Eingriff gebracht wird.

10. Verfahren gemäß Anspruch 9, wobei das Verfahren ein Verfahren zum Testen eines elektronischen Gerätes umfasst, wobei dieses Verfahren die folgenden weiteren Schritte umfasst:
das Montieren der Kombination aus batteriebetriebenem elektronischem Gerät (2) und dem Transportrahmen an einer Testhalteeinrichtung;
das Testen des elektronischen Gerätes; und
das Demontieren der Kombination aus elektronischem Gerät und Transportrahmen von der Testhalteeinrichtung.

## Revendications

1. Un châssis de transport (1) destiné à un dispositif électronique alimenté par batterie (2), ledit dispositif possédant un compartiment pour batterie (3) destiné à recevoir une batterie et possédant un couvercle amovible de compartiment pour batterie fixable sur ledit compartiment pour batterie via un moyen de fixation de couvercle de compartiment pour batterie (107), **caractérisé en ce que** ledit châssis de transport possède un moyen d'insertion (12, 14; 106, 108) configuré de façon à insérer et maintenir ledit dispositif via uniquement ledit compartiment pour batterie et/ou ledit moyen de fixation de couvercle de compartiment pour batterie.

2. Un châssis de transport selon la revendication 1, où ledit châssis est **caractérisé en outre par** des premier et deuxième éléments d'insertion (12, 14) positionnables pour une insertion avec uniquement ledit compartiment pour batterie (3) et/ou ledit moyen de fixation de couvercle de compartiment pour batterie (107), lesdits éléments d'insertion étant déplaçables entre une position d'utilisation et une position verrouillée dans laquelle ils sont plus éloignés l'un de l'autre que dans ladite position d'utilisation.

3. Un châssis de transport selon la revendication 2, où ledit châssis est **caractérisé en outre par** un moyen d'actionnement (20, 22, 24, 26) destiné à éloigner lesdits premier et deuxième éléments d'insertion l'un de l'autre afin de fixer ledit châssis audit dispositif.

4. Un châssis de transport selon la revendication 3, où ledit moyen d'actionnement est **caractérisé en outre par** un levier d'actionnement à came sollicité par un ressort (22), déplaçable entre une position de libération et une position de verrouillage, lesdits éléments d'insertion étant plus éloignés l'un de l'autre dans ladite position de verrouillage que dans ladite position de libération.

5. Un châssis de transport selon l'une quelconque des revendications 2 à 4, où ledit châssis est **caractérisé en outre par** une carcasse possédant un bloc fixe (12) s'étendant à partir d'une surface arrière (16) de celle-ci et constituant l'un desdits premier et deuxième éléments d'insertion, et possédant un bloc déplaçable (14) s'étendant à partir d'une surface arrière de celle-ci et constituant l'autre desdits premier et deuxième éléments d'insertion.

6. Un châssis de transport selon l'une quelconque des revendications 2 à 4, où ledit châssis est **caractérisé en outre par** une carcasse principale (102) possédant l'un desdits premier et deuxième éléments d'insertion s'étendant de celle-ci, et une partie coulissable (104) déplaçable vers et loin de ladite carcasse principale, ladite partie coulissable possédant l'autre desdits premier et deuxième éléments d'insertion s'étendant de celle-ci.

7. Un châssis de transport selon l'une quelconque des revendications 1 à 6, en combinaison avec un socle (4, 4'), ledit châssis de transport et ledit socle étant configurés de manière complémentaire de sorte que ledit châssis de transport est montable sur ledit socle.

8. Une combinaison d'un dispositif électronique alimenté par batterie (2), ledit dispositif possédant un compartiment pour batterie (3) destiné à recevoir une batterie et possédant un couvercle amovible de compartiment pour batterie fixable sur ledit compartiment pour batterie via un moyen de fixation de couvercle de compartiment pour batterie (107), et un châssis de transport selon l'une quelconque des revendications 1 à 7, où ledit châssis de transport est inséré uniquement avec ledit compartiment pour batterie et/ou ledit moyen de fixation de couvercle de compartiment pour batterie dudit dispositif électronique.

9. Un procédé de manipulation d'un dispositif électronique alimenté par batterie (2), ledit dispositif possédant un compartiment pour batterie (3) destiné à recevoir une batterie et possédant un couvercle amovible de compartiment pour batterie fixable sur ledit compartiment pour batterie via un moyen de fixation de couvercle de compartiment pour batterie (107), le procédé comprenant les opérations suivantes :
la combinaison du dispositif électronique (2) avec un châssis de transport selon l'une quelconque des revendications 1 à 7 par l'insertion dudit châssis de transport uniquement avec ledit compartiment pour batterie et/ou ledit moyen de fixation de couvercle de compartiment pour batterie dudit dispositif électronique.

10. Un procédé selon la revendication 9, où ledit procédé comprend un procédé de test d'un dispositif électronique, ledit procédé comprenant les opérations complémentaires suivantes :
le montage du dispositif électronique alimenté par batterie (2) et du châssis de transport combinés sur un équipement de test ;
le test du dispositif électronique ; et
le démontage du dispositif électronique et du châssis de transport combinés de l'équipement de test.
